# EUROPEAN PATENT APPLICATION

(11) **EP 1 492 387 A1**
(43) Date of publication of application: **29.12.2004**
(21) Application number: 03712755.2
(22) Date of filing: 19.03.2003
(51) Int. Cl.: H05B 33/04, H05B 33/10, H05B 33/14

(54) **ORGANIC ELECTROLUMINESCENCE DISPLAY PANEL**

(30) Priority: 29.03.2002 JP 2002094880; 29.03.2002 JP 2002094881
(71) Applicant: Pioneer Corporation, Tokyo 153-8654 (JP); Yoshizawa, Tatsuya, Tsurugashima-shi, Tokyo 350-2288 (JP)
(72) Inventor: YOSHIZAWA, Tatsuya, c/o Pioneer Corporation, Tsurugashima-shi, Tokyo 350-2288 (JP)
(74) Representative: Manitz, Finsterwald & Partner GbR
(86) International application number: PCT/JP2003/003313
(87) International publication number: WO 2003/084290

(57) **Abstract**

An organic electroluminescent display panel includes one or more organic electroluminescent devices comprising a first display electrode, one or more organic functional layers, which comprise a light-emitting layer comprising an organic compound, and a second display electrode, which are each layered in sequence. The display panel includes a support substrate, which carries the organic electroluminescent devices, and which comprises a resin material on the surface of the side facing the organic electroluminescent devices. The display panel includes an inorganic barrier film for covering the surface of the support substrate at least between the organic electroluminescent devices and the support substrate. The display panel includes a resin-contained film and a sealing region which covers an end face of the resin-contained film.

## Description

### TECHNICAL FIELD

The present invention relates to an organic electroluminescent device (hereinafter referred to as an organic EL device), which comprises one or more thin films (hereinafter referred to as organic functional layers) comprising a light-emitting layer constituted from an organic compound material that provides electroluminescence, which is the emission of light resulting from the application of an electric current. More particularly, the present invention relates to an organic electroluminescent display panel (hereinafter referred to as an organic EL display panel), which is constituted from one or more organic EL devices on top of a support substrate comprising a layer or film, the base material of which is either constituted from a resin, or, even if the base material is an inorganic material, comprises at the least a resin material on the surface, which faces the organic EL devices thereof.

### BACKGROUND ART

An organic EL device is basically configured such that an organic functional layer is sandwiched between an anode and a cathode, and excitons, which are formed when electrons and holes injected from the two electrodes recombine with one another, generate light when returning from an excited state to a normal state. For example, an organic EL device is constituted by sequentially layering an anode transparent electrode, an organic functional layer, and a cathode metallic electrode on top of a transparent substrate, and achieves light emission from the transparent substrate side. The organic functional layer is a layered body comprising either a single light-emitting layer, or a three-layered structure of an organic hole transporting layer, light-emitting layer and organic electron transporting layer, or a two-layered structure of an organic hole transporting layer and a light-emitting layer, and additionally has either an electron or a hole injecting layer or a carrier block layer inserted between the appropriate layers thereof.

As organic EL display panels, for example, matrix display type panels, and panels having a predetermined light-emitting pattern are known. Furthermore, the use of a resin substrate, such as a synthetic resin or plastic film, for the support substrate thereof has been proposed to make the organic EL display panel itself flexible.

Further, there is also a proposal for making organic EL display panels multicolored by arranging on the surface thereof light-emitting parts of a plurality of light-emitting colors (for example, red, blue and green). As multi-coloring methods, in addition to the method for constituting organic EL devices by selecting respective organic materials for respective specified light-emitting colors, there is a method, by which organic EL devices are formed or adhered on top of color-changing films, and the color-changing films intercept, and either resolve or change light of a predetermined color emitted from the organic EL devices, causing each color-changing film to emit light of a different color. In a color-changing film, there is, for example, a color filter, or a color-changing layer, what is called a CCM (Color Changing Method) layer. A color-changing layer is formed by arranging a predetermined fluorescent material portion on the surface of a predetermined base material, and coating a resin material (resin film) thereon. The resin film is provided as an overcoating film designed for planarization and as a protective film for use in forming an organic EL device. A substrate (color-changing substrate) comprising any of the color-changing films comprises a resin material on the surface of the side facing the organic EL device, and can also be utilized as a support substrate.

However, water vapor, oxygen and other so-called outgases are generated from the fluorescent material portion and the resin film thereon, which are located between the organic EL devices and color-changing substrate, by the inevitable annealing that takes place during fabrication, and these outgases diffuse inside the devices, resulting in the degradation of the organic EL devices. The problem is that, as a rule, if exposed to the atmosphere, organic EL devices are susceptible to degradation from the affects of moisture, oxygen and other such gases, and other types of molecules that exist in utilization environments, and characteristic degradation is especially conspicuous at the interfaces between the electrodes and the organic functional layer of an organic EL device, causing a so-called dark spot, which is a part where light is not emitted.

In addition, the organic EL display panel may have a support substrate structure in which the entire or portion of end face of so-called resin-contained film, which contains a resin material, is exposed to the open air probably.

However, when the end face of resin-contained film such as color-changing film, insulative film, smoothing film or the like of the substrate is exposed to the outside air, there occurs a problem that water vapor, oxygen entering thereto damages the organic EL device.

### DISCLOSURE OF THE INVENTION

Accordingly, an object of the present invention is to provide an organic EL device and an organic EL display panel in which light-emitting characteristics are not susceptible to degradation resulting from moisture.

According to the present invention, there is provided an organic electroluminescent display panel comprising:
one or more organic electroluminescent devices each comprising
   a first display electrode,
   one or more organic functional layers each including a light-emitting layer formed from an organic compound, and
   a second display electrode, which are layered sequentially; and
a support substrate which carries said organic electroluminescent devices, and which contains a resin material in the surface of the side facing said organic electroluminescent devices,
wherein said organic electroluminescent display panel further comprises an inorganic barrier film for covering the surface of said support substrate is provided at least between said organic electroluminescent devices and said support substrate.

In the organic electroluminescent display panel according to the invention, said support substrate comprises a color-changing substrate provided with a color-changing film.

In the invention, the organic electroluminescent display panel further comprises a second inorganic barrier film covering the surface of said substrate that is opposite the surface making contact with said organic electroluminescent device.

In the organic electroluminescent display panel according to the invention, said inorganic barrier film covers the end face of said color-changing film.

In the organic electroluminescent display panel according to the invention, said inorganic barrier film comprises silicon oxynitride.

In the organic electroluminescent display panel according to the invention, said inorganic barrier film of silicon oxynitride has a nitrogen/oxygen ratio in a range of 0.13 to 2.88.

In the organic electroluminescent display panel according to the invention, said inorganic barrier film is formed by sputtering.

In the invention, the organic electroluminescent display panel further comprises a sealing film, which comes in contact with said organic electroluminescent device, and covers the entire device from the back face.

In the organic electroluminescent display panel according to the invention, said sealing film is an inorganic passivation film, and said organic electroluminescent device is entirely covered in an airtight condition by said inorganic barrier film and said sealing film.

In the organic electroluminescent display panel according to the invention, the surface of said support substrate comprises a resin film, and the end face of said resin film is covered by said inorganic barrier film, and is confined inside a region in which said sealing film makes contact with said inorganic barrier film.

In the invention, the organic electroluminescent display panel further comprises: a seal housing, which is fastened to said support substrate, and which covers said organic electroluminescent device entirely from the back face; and an inert material, which is filled inside said seal housing.

In the organic electroluminescent display panel according to the invention, said seal housing comprises a gas trapping material on the inside wall thereof.

In the organic electroluminescent display panel according to the invention, said organic electroluminescent device is entirely covered in an airtight condition by said inorganic barrier film and said seal housing.

In the organic electroluminescent display panel according to the invention, the surface of said support substrate comprises a resin film, and the end face of said resin film is covered by said inorganic barrier film, and is confined inside a region in which said seal housing makes contact with said inorganic barrier film.

According to the present invention, there is also provided another organic electroluminescent display panel comprising:
one or more organic electroluminescent devices each comprising
   a first display electrode,
   one or more organic functional layers each including a light-emitting layer formed from an organic compound, and
   a second display electrode, which are layered sequentially;
a resin-contained film which carries said organic electroluminescent devices, and which contains a resin material in the surface of the side facing said organic electroluminescent devices, and
a support substrate which supports said resin-contained film,
wherein said organic electroluminescent display panel further comprises a sealing region which covers an end face of said resin-contained film.

In the organic electroluminescent display panel according to the invention, said sealing region comprises: a seal housing, which is fastened to said support substrate, and which covers said organic electroluminescent device entirely from the back face; and an inert material, which is filled inside said seal housing.

In the organic electroluminescent display panel according to the invention, said seal housing comprises a gas trapping material on the inside wall thereof.

In the organic electroluminescent display panel according to the invention, said sealing region comprises a sealing film, which comes in contact with said organic electroluminescent device, and covers the entire device from the back face.

In the organic electroluminescent display panel according to the invention, said sealing film is an inorganic passivation film, and said organic electroluminescent device is entirely covered in an airtight condition by said inorganic barrier film and said sealing film.

In the organic electroluminescent display panel according to the invention, said support substrate is made of resin, and said display panel further comprises an inorganic barrier film for covering the surface of said support substrate is provided at least between said organic electroluminescent devices and said support substrate.

In the invention, the organic electroluminescent display panel further comprises a second inorganic barrier film covering the surface of said substrate that is opposite the surface making contact with said organic electroluminescent device.

In the organic electroluminescent display panel according to the invention, said inorganic barrier film comprises silicon oxynitride.

In the organic electroluminescent display panel according to the invention, said inorganic barrier film is formed by sputtering.

In the organic electroluminescent display panel according to the invention, said support substrate comprises a color-changing substrate provided with a color-changing film.

### BRIEF DESCRIPTION OF THE DRAWINGS

Fig. 1 is a simplified enlarged cross-sectional view showing an organic EL device of an embodiment according to the present invention.
Figs. 2 through 8 are simplified enlarged cross-sectional views each showing an organic EL device of other embodiments according to the present invention.
Fig. 9 is a simplified enlarged partial rear view showing an organic EL display panel of another embodiment according to the present invention.
Figs. 10 through 14 are simplified enlarged cross-sectional views each showing an organic EL device of other embodiments according to the present invention.
Fig. 15 is a simplified enlarged partial rear view showing an organic EL display panel of another embodiment according to the present invention.

### DETAILED DESCRIPTION OF THE INVENTION

A first aspect of the embodiment according to the present invention will be explained hereinbelow by referring to the figures.

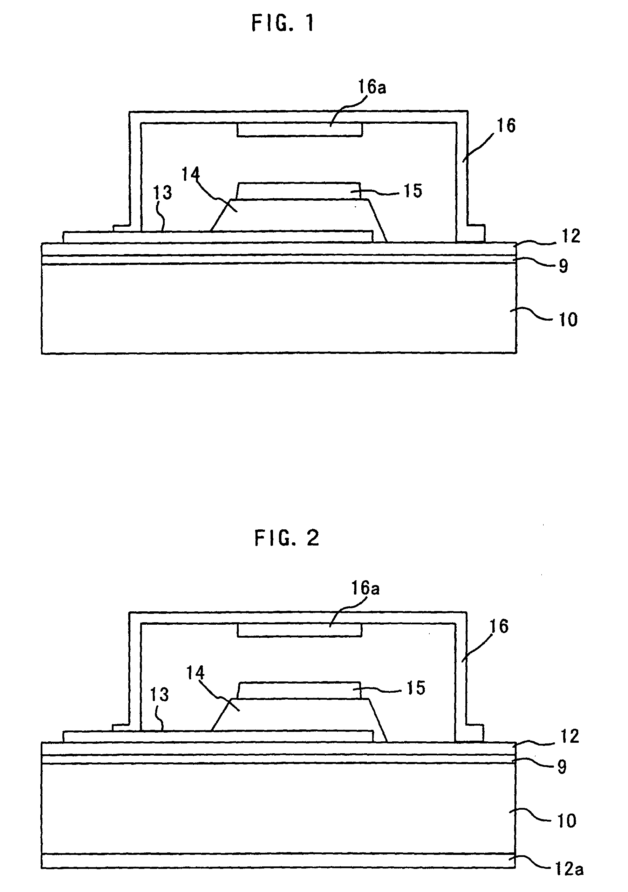

As shown in Fig. 1, an organic EL device of the embodiment is formed on top of a color-changing substrate 10 comprising a resin film 9 covered by a moisture-proof inorganic barrier film 12 comprising, for example, silicon oxynitride. The organic EL device is constituted by layering sequentially on top of this inorganic barrier film 12 a first display electrode 13 (anode transparent electrode), one or more organic functional layers 14 comprising a light-emitting layer, which comprises an organic compound, and a second display electrode 15 (cathode metallic electrode). Further, the organic EL device comprises a gas-impermeable seal housing 16, which comprises a gas trapping material 16a on the inside wall, and which is fastened by adhesive to color-changing substrate 10, and seals the substrate together with the organic EL device. An inert material, such as, for example, dry nitrogen (N₂), is filled in the space inside seal housing 16.

It is desirable that the nitrogen/oxygen ratio of the silicon oxynitride of the inorganic barrier film be between 0.13 and 2.88 for maintaining moisture-proofness. If it is higher than this, the residual stress of the film becomes higher, and if it is lower than this, it becomes impossible to adequately prevent the penetration of moisture and so forth into the organic functional layer of the organic EL device.

For example, a transparent electrode (first display electrode) comprising indium tin oxide (ITO) is formed on color-changing substrate 10 by either vapor deposition or sputtering. An organic functional layer 14 is formed thereon via the sequential vapor deposition of a hole injecting layer comprising copper phthalocyanine, a hole transporting layer comprising TPD (triphenylamine derivative), a light-emitting layer comprising Alq3 (aluminum chelate complex), and an electron injecting layer comprising Li₂O (lithium oxide). In addition, a metallic electrode (second display electrode) 15 comprising Al (aluminum) is formed thereon by vapor deposition so as to face the electrode pattern of transparent electrode 13.

It is desirable that the surface of the color-changing substrate, which is covered by the inorganic barrier film, comprise at the least a surface that comes in contact with the organic EL devices, a surface between the organic EL devices, a surface surrounding the organic EL devices, and a surface on the other side of the surface that makes contact with the organic EL devices. This is to prevent the penetration of moisture and the like into the organic functional layers.

In the present invention, when an organic EL device is fabricated on top of a color-changing substrate, a color-changing substrate having adequate moisture-proofness even for an organic EL device can be achieved by using a silicon oxynitride film as the moisture-proofing film essential for enhancing the maintainability of the device.

As shown in Fig. 1, in the first embodiment, an inorganic barrier film 12 is formed on the surface of this resin film of a color-changing substrate 10 comprising a resin film 9.

A second embodiment shown in Fig. 2 is the same as the first embodiment with the exception of comprising a second inorganic barrier film 12a, which covers the surface on the other side of the surface that makes contact with the organic EL device on color-changing substrate 10, and inorganic barrier films 12, 12a are formed on both sides of color-changing substrate 10. By covering both sides of the color-changing substrate with inorganic barrier films, it is possible to prevent the warping of color-changing substrate 10.

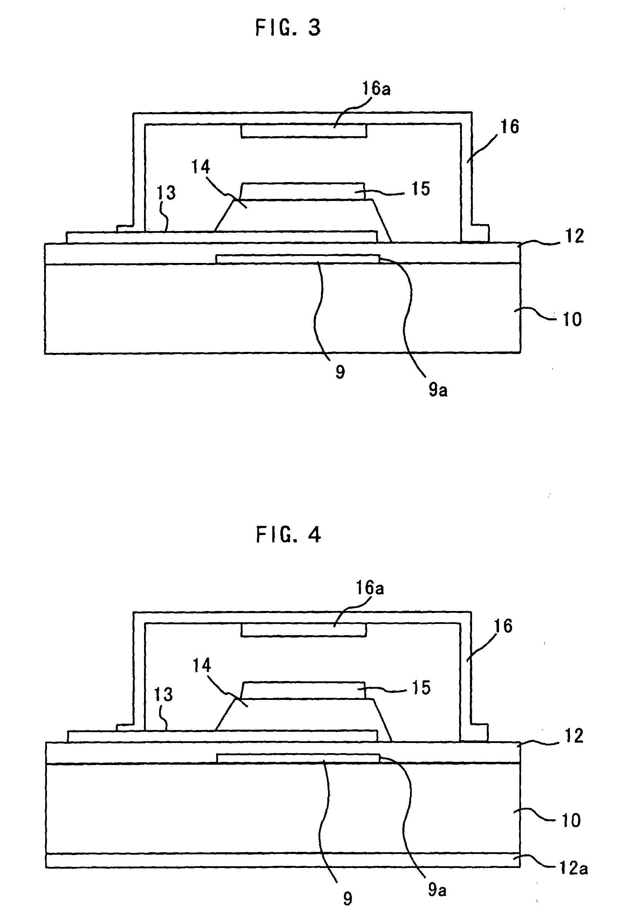

A third embodiment shown in Fig. 3 is the same as the first embodiment with the exception of constituting a structure in which the end face 9a of resin film 9 of color-changing substrate 10 is covered by inorganic barrier film 12, and is confined to an internal region surrounded by seal housing 16, thus not being exposed to the outside air, and the penetration of moisture and the like from the end face 9a of resin film 9 is prevented.

A fourth embodiment shown in Fig. 4 is the same as the second embodiment with the exception of constituting a structure in which the end face 9a of resin film 9 of color-changing substrate 10 is covered by inorganic barrier film 12, and is confined to an internal region surrounded by seal housing 16, thus not being exposed to the outside air, and the penetration of moisture and the like from the end face 9a of resin film 9 is prevented.

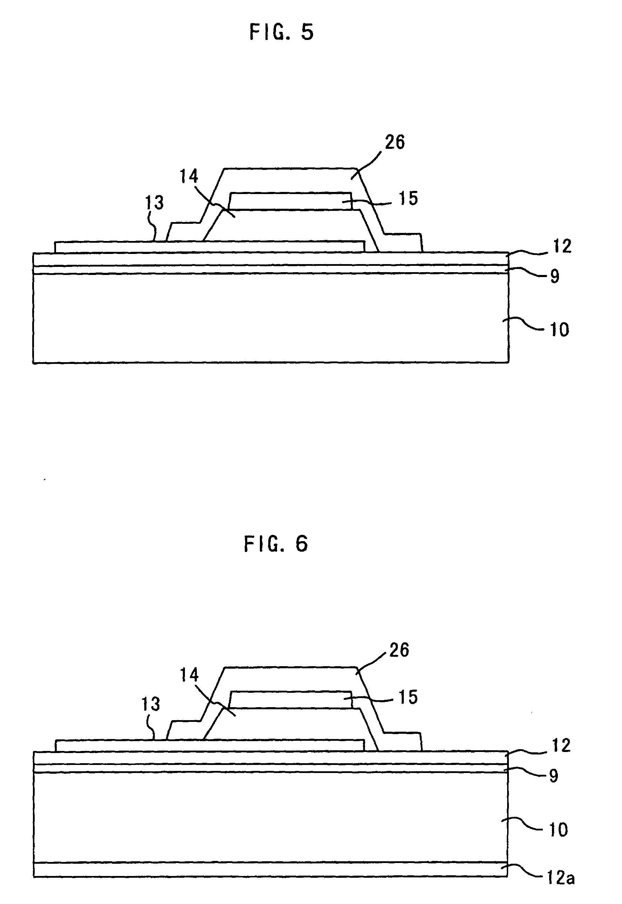

A fifth embodiment shown in Fig. 5 is the same as the first embodiment with the exception that the gas trapping material-equipped seal housing is replaced with a sealing film 26 air-tightly sealing the entire device. The organic EL device has a sealing film 26 covering everything from the back face of this second display electrode 15. Sealing film 26, which covers from the back face of the organic EL device, is an inorganic passivation film. Further, multi-layering can also be done by disposing a sealing film comprising a resin on top of this inorganic passivation film. Further, an inorganic passivation film comprising an inorganic material can be provided once again on the outermost surface of the resin sealing film. The inorganic passivation film comprises an inorganic material such as the above-mentioned silicon oxynitride, silicon nitride or some other such nitride, or an oxide or carbon. As the resin constituting the sealing film, a fluorocarbon or silicon-based resin, plus a photoresist, polyimide or other such synthetic resin can be used.

A sixth embodiment shown in Fig. 6 is the same as the second embodiment with the exception that the gas trapping material-equipped seal housing is replaced with a sealing film 26 tightly sealing the entire device.

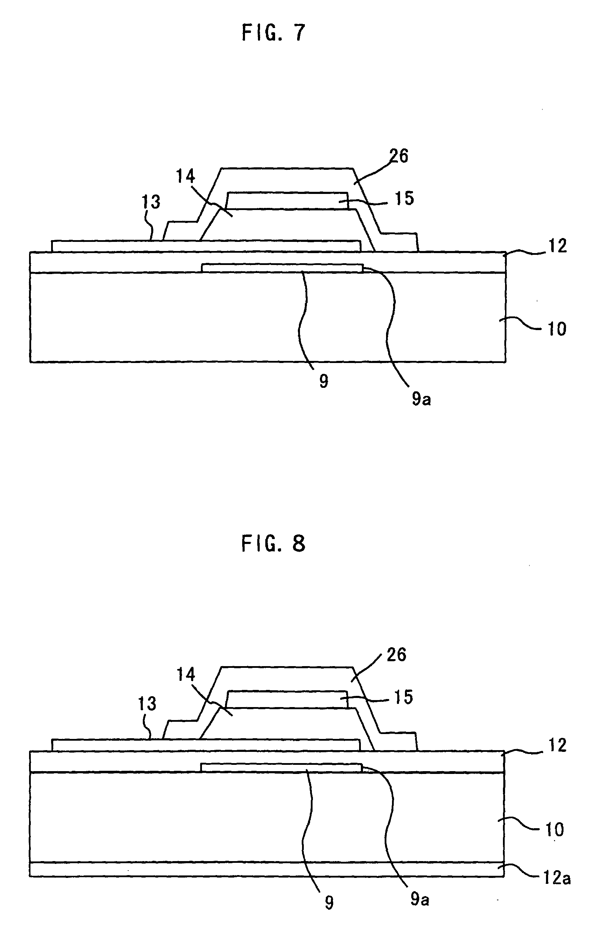

A seventh embodiment shown in Fig. 7 is the same as the third embodiment with the exception that the gas trapping material-equipped seal housing is replaced with a sealing film 26 tightly sealing the entire device.

An eighth embodiment shown in Fig. 8 is the same as the fourth embodiment with the exception that the gas trapping material-equipped seal housing is replaced with a sealing film 26 tightly sealing the entire device.

It is desirable that the base material of either the support substrate or the color-changing substrate utilized in the present invention have greater than 50% transmittance of light in the visible region, and be a smooth substrate. More specifically, a glass plate or a high-molecular compound plate can be cited as examples. As glass plates, there are, in particular, plates made of soda-lime glass, glass containing barium-strontium, lead glass, aluminosilicate glass, borosilicate glass, barium-borosilicate glass, and quartz. Further, as high-molecular compound plates, there are plates made of polycarbonate, acrylic, polyethylene terephthalate, polyether sulfide, and polysulfone. Since a glass plate in particular can almost completely exclude outside air, it is preferable to use glass plates in the first, third, fifth and seventh embodiments. It is preferable to use high-molecular compound plates in the second, fourth, sixth and eighth embodiments.

In the color-changing substrate utilized in the present invention, one or more predetermined fluorescent material portions are separated and arranged flatly on the surface of a predetermined base material, and each predetermined fluorescent material portion is arranged corresponding to the location of an organic EL device. The color-changing film utilized in the present invention can be a color filter that adjusts the color by either resolving or shading the light of a light-emitting member. Further, in a color-changing substrate, contrast can be enhanced between the respective predetermined fluorescent material portions by excluding light from the emitted light of an organic EL device and from each predetermined fluorescent material portion, and a black matrix can be arranged to reduce dependency on the angle of visibility.

A predetermined fluorescent material portion, for example, comprises either a fluorescent dye and a resin, or a fluorescent dye alone, and a predetermined fluorescent material portion comprising a fluorescent dye and a resin is a solid in which the fluorescent dye is distributed inside either a colored resin or a binder resin. Concerning specific fluorescent dyes, as fluorescent dyes for converting from near ultraviolet light to a blue light emission from the emitted light of a purple organic EL device there are 1, 4-bis (2-methylstyryl) benzene, trans-4, 4'-diphenylstilbene, and 7-hydroxy-4-methylcoumarin.

As fluorescent dyes for converting from the emitted light of either a blue, blue-green, or white light-emitting member to a green emitted light there are 2,3,5,6-1H, 4H-tetrahydro-8-trifluoromethylquinolizino (9,9a,1-gh) coumarin, 3-(2'-benzothiazolyl)-7-diethylaminocumarin, 3-(2'-benzimidazolyl)-7-N,N-diethylaminocumarin.

As for fluorescent dyes for converting from blue to green emitted light of a light-emitting member to orange to red emitted light, there are 4-dicyanomethylene-2-methyl-6-(p-dimethylaminostyryl)-4h-pyran, and 1-ethyl-2-(4-(p-dimethylaminophenyl)-1,3-butadienyl)-pyridinium-perchlorate.

Further, pigmented resins, such as polyester methacrylate, polyvinylchloride, vinylchloridevinylacetate copolymer, alkyd resin, aromatic sulfonamide resin, urea resin, melamine resin, and benzoguanamine resin, can be pigmented by working such fluorescent dyes into the pigmented resins in advance.

As binder resins, there are, for example, the transparent materials polymethyl-methacrylate, polyacrylate, polycarbonate, polyvinyl alcohol, polyvinyl-pyrolidone, hyroxyethylcellulose, and carboxymethylcellulose.

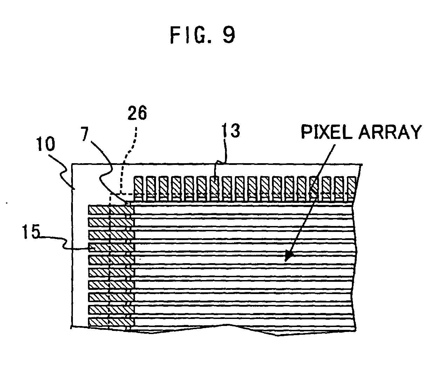

Fig. 9 is a partial enlarged rear view of an organic EL display panel comprising a plurality of organic EL devices in the ninth embodiment. The organic EL display panel, as shown in the figure, is comprised of a plurality of organic EL devices, which are completely covered by sealing film 26, and which are arranged in a matrix on top of color-changing substrate 10. The organic EL display panel is constituted by sequentially layering column electrodes 13 comprising transparent electrode layers (anode first display electrodes), organic functional layers, and row electrodes 15 comprising metallic electrode layers that intersect with these column electrodes (second display electrodes) on a silicon oxynitride film. Column electrodes are each formed in a long, narrow strip, and are arranged at predetermined intervals so as to be parallel to one another, and the same holds true for the row electrodes. In this way, a matrix display-type display panel has an image display matrix comprising a plurality of light-emitting pixels of organic EL devices formed at the plurality of intersecting points of the column and row electrodes. First display electrodes 13 can be constituted from metallic bus lines, which electrically connect insular transparent electrodes in the horizontal direction. The organic EL display panel comprises a plurality of barrier ribs 7 disposed between the organic EL devices on the silicon oxynitride film of color-changing substrate 10. A sealing film 26 is formed on top of second display electrodes 15 and barrier ribs 7. By selecting and suitably layering the materials of the organic functional layers, each of these organic functional layers can constitute light-emitting portions of red R, green G and blue B.

Each organic EL device on this panel comprises a first display electrode 13, one or more organic functional layers 14 comprising a light-emitting layer comprised from an organic compound, and a second display electrode 15, which are stacked in order on top of color-changing substrate 10. Barrier plates 7 are disposed between organic EL devices so as to protrude from the color-changing substrate.

In addition, the organic EL display panel, just like the organic EL devices, can be provided with multiple layers of films of an inorganic passivation film and an organic resin sealing film as part of sealing film 26, which covers barrier ribs 7 from the back face. An inorganic passivation film comprising an inorganic compound can be provided once again on the uppermost surface of this resin sealing film.

According to the present invention, since the constitution is such that the resin surface of the support substrate containing a resin material is covered by an inorganic barrier film, the degradation of a device pursuant to the penetration of oxygen and moisture from outside the device and outgases from the color filter and color-changing substrate can be held in check, making it possible to provide a highly reliable organic EL display and organic EL devices.

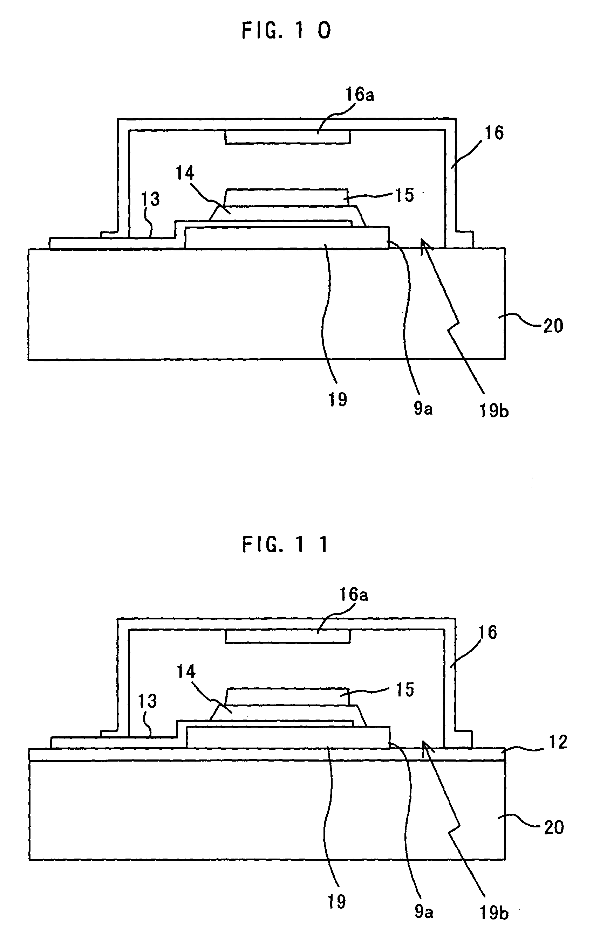

Fig. 10 shows the tenth embodiment of organic EL display panel. As shown in the Figure, the organic EL device is formed on a color filter 19 containing a resin binder formed on a support substrate 20 made of glass. The organic EL device is constituted by layering sequentially on top of this color filter 19 a first display electrode 13 (anode transparent electrode), one or more organic functional layers 14 comprising a light-emitting layer, which comprises an organic compound, and a second display electrode 15 (cathode metallic electrode). Further, the organic EL device comprises a gas-impermeable seal housing 16, which comprises a gas trapping material 16a on the inside wall, and which is fastened by adhesive to support substrate 20, and seals the substrate together with the organic EL device. An inert material, such as, for example, dry nitrogen (N₂), is filled in the space inside seal housing 16. Thus the color filter 19 becomes not to be exposed to outside by the sealing region 19b defined by the glass substrate, the seal housing, the inert material and the bonding portion thereof. The sealing region 19b prevents invasion of water moisture or the like to the devices from the end face 9a of the color filter 19.

For example, a transparent electrode (first display electrode) comprising indium tin oxide (ITO) is formed on support substrate 20 by either vapor deposition or sputtering. An organic functional layer 14 is formed thereon via the sequential vapor deposition of a hole injecting layer comprising copper phthalocyanine, a hole transporting layer comprising TPD (triphenylamine derivative), a light-emitting layer comprising Alq3 (aluminum chelate complex), and an electron injecting layer comprising Li₂O (lithium oxide). In addition, a metallic electrode (second display electrode) 15 comprising Al (aluminum) is formed thereon by vapor deposition so as to face the electrode pattern of transparent electrode 13.

The eleventh embodiment shown in Fig. 11 is the same as the tenth embodiment except support substrate 20 is made of resin, and an inorganic barrier film 12 for covering the surface of the support substrate is provided between the organic EL device and the support substrate. The inorganic barrier film 12 may be made of silicon oxynitride for example to have a moisture-proof property. It is desirable that the nitrogen/oxygen ratio of the silicon oxynitride of the inorganic barrier film be between 0.13 and 2.88 for maintaining moisture-proofness. If it is higher than this, the residual stress of the film becomes higher, and if it is lower than this, it becomes impossible to adequately prevent the penetration of moisture and so forth into the organic functional layer of the organic EL device. It is desirable that the surface of support substrate 20, which is covered by the inorganic barrier film, comprise at the least a surface that comes in contact with the organic EL devices, a surface between the organic EL devices, a surface surrounding the organic EL devices, and a surface on the other side of the surface that makes contact with the organic EL devices. This is to prevent the penetration of moisture and the like into the organic functional layers. In addition, there may be provided with a second inorganic barrier film which covers the surface on the other side of the surface that makes contact with the organic EL device in the support substrate 20. By covering both sides of the support substrate with inorganic barrier films, it is possible to prevent the warping of support substrate 20.

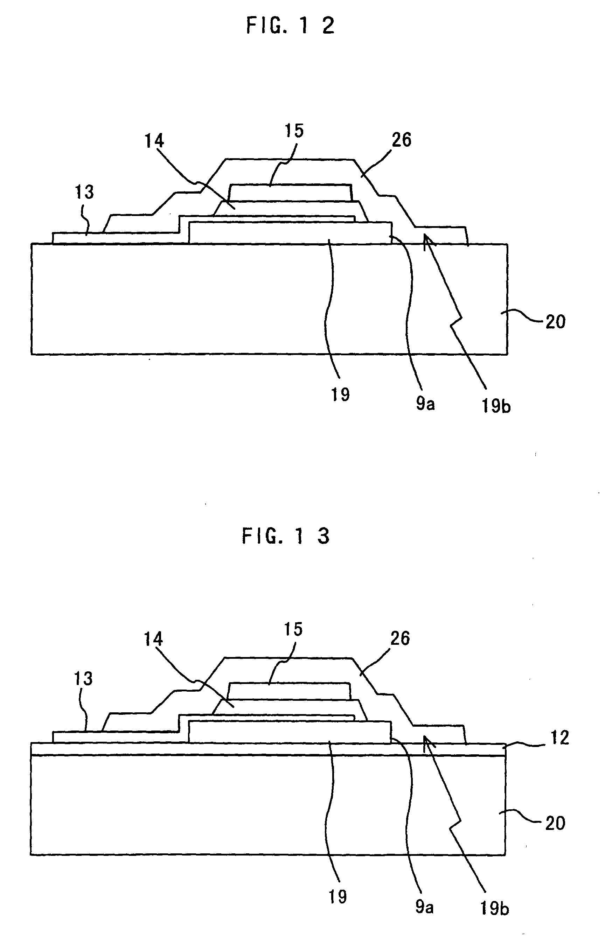

A twelfth embodiment shown in Fig. 12 is the same as the tenth embodiment with the exception that the gas trapping material-equipped seal housing is replaced with a sealing film 26 tightly sealing the entire device. The sealing region 19b including the sealing film 26 covering the end face 9a prevents invasion of water moisture to the devices from the end face 9a of the color filter 19. The sealing film 26, which covers from the back face of the organic EL device, is an inorganic passivation film. Further, multi-layering can also be done by disposing a sealing film comprising a resin on top of this inorganic passivation film. Further, an inorganic passivation film comprising an inorganic material can be provided once again on the outermost surface of the resin sealing film. The inorganic passivation film comprises an inorganic material such as the above-mentioned silicon oxynitride, a silicon nitride or some other such nitride, or an oxide or carbon. As the resin constituting the sealing film, a fluorocarbon or silicon-based resin, plus a photoresist, polyimide or other such synthetic resin can be used.

A thirteenth embodiment shown in Fig. 13 is the same as the second embodiment with the exception that the gas trapping material-equipped seal housing is replaced with a sealing film 26 air-tightly sealing the entire device.

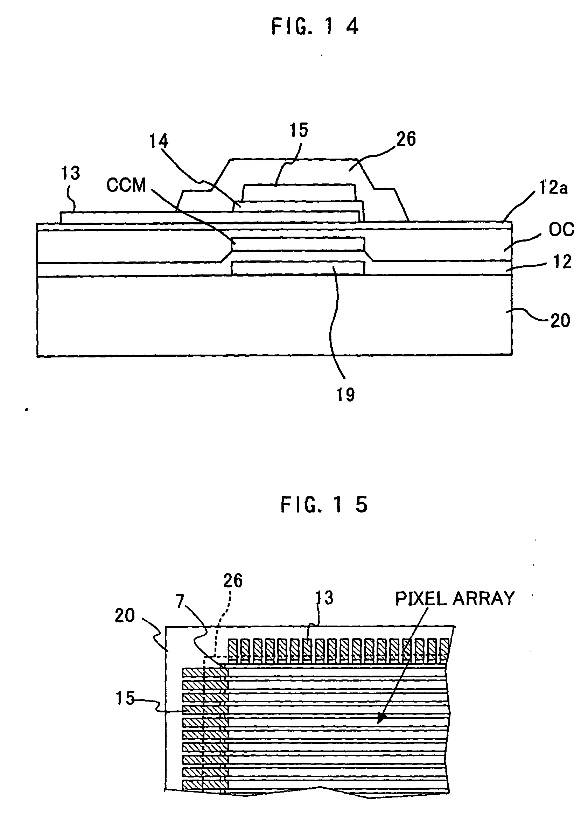

In any embodiments above mentioned, the color filter including the resin binder may be another film containing a resin material such as color-changing film, insulative film, smoothing film or the like. To prevent the invasion of outgas from the color filter, a structure as shown in Fig. 14 is revealed. There are formed in turn, on or over a support substrate 20, a color filter 19 having a predetermined size, an inorganic barrier film 12 covering the color filter thoroughly, a color-changing film CCM adapted to the color filter 19 and having a predetermined size, a resin overcoating film OC covering them thoroughly, and a second inorganic barrier film 12a. The first display electrode 13 of the organic EL device is formed on the second inorganic barrier film 12a. In this way, the outgas invasion into the device is prevented by such a formation that a functional member such as the color-changing film CCM, the color filter 19 etc. is embedded within the inorganic and organic multi-layer. The invention is constructed in such a manner that all layers constituting the devices including resin materials except a sealing material are not exposed to the outside air.

The resin-contained film made of an organic material has a remarkable high gaseous permeability in comparison with an inorganic material and the organic EL devices are shut out within the sealing structure using the same to be non-exposure to the outside. Therefore, it is possible to effectively reduce the deterioration of organic EL devices caused by invasion of water vapor and oxygen from the outside. In addition, even if a sealing structure without use of an organic sealing material and gas trapping material is employed, organic EL devices may be in a good state of preservation.

It is desirable that the base material of either the support substrate or the color-changing substrate utilized in the present invention have greater than 50% transmittance of light in the visible region, and be a smooth substrate. More specifically, a glass plate or a high-molecular compound plate can be cited as examples. As glass plates, there are, in particular, plates made of soda-lime glass, glass containing barium-strontium, lead glass, aluminosilicate glass, borosilicate glass, barium-borosilicate glass, and quartz. Further, as high-molecular compound plates, there are plates made of polycarbonate, acrylic, polyethylene terephthalate, polyether sulfide, and polysulfone.

Fig. 15 is a partial enlarged rear view of an organic EL display panel comprising a plurality of organic EL devices of the fourteenth embodiment. The organic EL display panel, as shown in the figure, is comprised of a plurality of organic EL devices, which are completely covered by sealing film 26, and which are arranged in a matrix on top of support substrate 20. The organic EL display panel is constituted by sequentially layering column electrodes 13 comprising transparent electrode layers (anode first display electrodes), organic functional layers, and row electrodes 15 comprising metallic electrode layers that intersect with these column electrodes (second display electrodes) on a silicon oxynitride film. Column electrodes are each formed in a long, narrow strip, and are arranged at predetermined intervals so as to be parallel to one another, and the same holds true for the row electrodes. In this way, a matrix display-type display panel has an image display matrix comprising a plurality of light-emitting pixels of organic EL devices formed at the plurality of intersecting points of the column and row electrodes. First display electrodes 13 can be constituted from metallic bus lines, which electrically connect insular transparent electrodes in the horizontal direction. The organic EL display panel comprises a plurality of barrier ribs 7 disposed between the organic EL devices on the silicon oxynitride film of support substrate 20. A sealing film 26 is formed on top of second display electrodes 15 and barrier ribs 7. By selecting and suitably layering the materials of the organic functional layers, each of these organic functional layers can constitute light-emitting portions of red R, green G and blue B.

Each organic EL device on this panel comprises a first display electrode 13, one or more organic functional layers 14 comprising a light-emitting layer comprised from an organic compound, and a second display electrode 15, which are stacked in order on top of support substrate 20. Barrier plates 7 are disposed between organic EL devices so as to protrude from the color-changing substrate.

In addition, the organic EL display panel, just like the organic EL devices, can be provided with multiple layers of films of an inorganic passivation film and an organic resin sealing film as part of sealing film 26, which covers barrier ribs 7 from the back face. An inorganic passivation film comprising an inorganic compound can be provided once again on the uppermost surface of this resin sealing film.

In the examples explained hereinabove, sputtering was used as the method of fabricating an inorganic barrier film for shutting out moisture and the like, but it is not limited to this, and vapor growth methods, such as plasma CVD (Chemical Vapor Deposition) and vacuum deposition can also be applied.

According to the present invention, since the constitution is such that the end face of resin-contained film i.e., resin surface of the support substrate containing a resin material is covered by an inorganic barrier film, the degradation of a device pursuant to the penetration of oxygen and moisture from outside air can be reduced. Therefore, it is possible to provide a highly reliable organic EL display and organic EL devices.

## Claims

1. An organic electroluminescent display panel comprising:
one or more organic electroluminescent devices each comprising
a first display electrode,
one or more organic functional layers each including a light-emitting layer formed from an organic compound, and
a second display electrode, which are layered sequentially; and
a support substrate which carries said organic electroluminescent devices, and which contains a resin material in the surface of the side facing said organic electroluminescent devices,
wherein said organic electroluminescent display panel further comprises an inorganic barrier film for covering the surface of said support substrate is provided at least between said organic electroluminescent devices and said support substrate.

2. An organic electroluminescent display panel according to Claim 1, wherein said support substrate comprises a color-changing substrate provided with a color-changing film.

3. An organic electroluminescent display panel according to either of Claims 1 or 2, further comprising a second inorganic barrier film covering the surface of said substrate that is opposite the surface making contact with said organic electroluminescent device.

4. An organic electroluminescent display panel according to any one of Claims 1 through 3, wherein said inorganic barrier film covers the end face of said color-changing film.

5. An organic electroluminescent display panel according to any one of Claims 1 through 4, wherein said inorganic barrier film comprises silicon oxynitride.

6. An organic electroluminescent display panel according to any one of Claims 1 through 5, wherein said inorganic barrier film of silicon oxynitride has a nitrogen/oxygen ratio in a range of 0.13 to 2.88.

7. An organic electroluminescent display panel according to any one of Claims 1 through 6, wherein said inorganic barrier film is formed by sputtering.

8. An organic electroluminescent display panel according to any one of Claims 1 through 7, further comprising a sealing film, which comes in contact with said organic electroluminescent device, and covers the entire device from the back face.

9. An organic electroluminescent display panel according to Claim 8, wherein said sealing film is an inorganic passivation film, and said organic electroluminescent device is entirely covered in an airtight condition by said inorganic barrier film and said sealing film.

10. An organic electroluminescent display panel according to Claim 9, wherein the surface of said support substrate comprises a resin film, and the end face of said resin film is covered by said inorganic barrier film, and is confined inside a region in which said sealing film makes contact with said inorganic barrier film.

11. An organic electroluminescent display panel according to any one of Claims 1 through 7, further comprising: a seal housing, which is fastened to said support substrate, and which covers said organic electroluminescent device entirely from the back face; and an inert material, which is filled inside said seal housing.

12. An organic electroluminescent display panel according to Claim 11, wherein said seal housing comprises a gas trapping material on the inside wall thereof.

13. An organic electroluminescent display panel according to either of Claims 11 or 12, wherein said organic electroluminescent device is entirely covered in an airtight condition by said inorganic barrier film and said seal housing.

14. An organic electroluminescent display panel according to any one of Claims 11 through 13, wherein the surface of said support substrate comprises a resin film, and the end face of said resin film is covered by said inorganic barrier film, and is confined inside a region in which said seal housing makes contact with said inorganic barrier film.

15. An organic electroluminescent display panel comprising:
one or more organic electroluminescent devices each comprising
a first display electrode,
one or more organic functional layers each including a light-emitting layer formed from an organic compound, and
a second display electrode, which are layered sequentially;
a resin-contained film which carries said organic electroluminescent devices, and which contains a resin material in the surface of the side facing said organic electroluminescent devices, and
a support substrate which supports said resin-contained film,
wherein said organic electroluminescent display panel further comprises a sealing region which covers an end face of said resin-contained film.

16. An organic electroluminescent display panel according to Claim 15, wherein said sealing region comprises: a seal housing, which is fastened to said support substrate, and which covers said organic electroluminescent device entirely from the back face; and an inert material, which is filled inside said seal housing.

17. An organic electroluminescent display panel according to Claim 16, wherein said seal housing comprises a gas trapping material on the inside wall thereof.

18. An organic electroluminescent display panel according to Claim 15, wherein said sealing region comprises a sealing film, which comes in contact with said organic electroluminescent device, and covers the entire device from the back face.

19. An organic electroluminescent display panel according to Claim 18, wherein said sealing film is an inorganic passivation film, and said organic electroluminescent device is entirely covered in an airtight condition by said inorganic barrier film and said sealing film.

20. An organic electroluminescent display panel according to any one of Claims 15 through 19, wherein said support substrate is made of resin, and said display panel further comprises an inorganic barrier film for covering the surface of said support substrate is provided at least between said organic electroluminescent devices and said support substrate.

21. An organic electroluminescent display panel according to Claim 20, further comprising a second inorganic barrier film covering the surface of said substrate that is opposite the surface making contact with said organic electroluminescent device.

22. An organic electroluminescent display panel according to either of Claims 20 or 21, wherein said inorganic barrier film comprises silicon oxynitride.

23. An organic electroluminescent display panel according to any one of Claims 20 through 22, wherein said inorganic barrier film is formed by sputtering.

24. An organic electroluminescent display panel according to any one of Claims 15 through 23, wherein said support substrate comprises a color-changing substrate provided with a color-changing film.
